# EUROPEAN PATENT APPLICATION

(11) **EP 1 867 475 A2**
(43) Date of publication of application: **19.12.2007**
(21) Application number: 07109667.1
(22) Date of filing: 05.06.2007
(51) Int. Cl.: B41C 1/10

(54) **Split drum platesetter for imaging printing plates**

(30) Priority: 13.06.2006 US 452145
(71) Applicant: AGFA CORPORATION, Ridgefield Park, NJ 07660-2199 (US)
(72) Inventor: Wolber, John W., Nashua, MA 03064 (US); Busaard, Mark L., Salem, MA 03079 (US)
(74) Representative: Goedeweeck, Rudi

(57) **Abstract**

An external drum platesetter (100), including two or more drums (100,120) aligned along a same rotational axis (190) for supporting one or more printing plates (130), a single imaging head (150) mounted on and moveable along one or more rails (160) positioned parallel to the rotational axis (190), where the imaging head (150) may include a laser source or ink jets for transferring an image to the one or more printing plates (130), one or more motors (170) for rotating the drums (110,120) together or individually and a computer (180) for controlling operation of the platesetter in accordance with instructions stored or transferred to the computer (180).

## Description

### Technical Field

This invention, in the field of pre-press and industrial printing, is generally directed towards saving time and money when making printing plates, and is more specifically directed towards increasing throughput in a machine for making printing plates, e.g. a platesetter.

### Background Art

A platesetter is used to transfer an image to a printing plate which, in turn, is mounted on a commercial printing press, such as those made by Heidelberger Druckmaschinen AG of Germany. The image from the printing plate is then transferred on the press, for example by offset printing, to a final product such as a newspaper, magazine, poster, packaging, etc.

The process of transferring text and/or graphic information from electronic form to visual form on a printing plate medium is called imaging. In an external drum platesetter, a medium is mounted onto the external surface of the drum, then the drum is rotated while an imaging beam traverses longitudinally along the length of the drum and an image is transferred to the plate. The information is typically transferred by a laser beam or beams. The medium may be a printing plate that is sensitive to a specific wavelength, such as a photosensitive substrate which is sensitive to visible light, a plate sensitive to ultraviolet light, or a plate which requires high power for thermal fusion or ablation of particles on the plate. The frequency and intensity of the laser beam will thus vary according to the requirements for imaging the printing plate.

Two key considerations in the manufacture and development of an external drum platesetter are (1) minimizing or lowering the costs to build and operate the machine, and (2) increasing throughput of printing plates, in other words, increasing the number of printing plates that are imaged on the platesetter over a given period of time. These are ongoing problems in the printing industry.

Throughput of printing plates can be increased for example by (1) increasing the speed of rotation of the drum, (2) increasing the power of the laser source, (3) increasing the number of imaging beams being used, (4) and minimizing the down time, defined as the time necessary to stop the drum from rotating, remove the imaged printing plate, install a new blank printing plate to be imaged, resetting all hardware and software to default positions prior to imaging, and bringing the drum up to speed again for imaging. Each of the above factors are limited whereby at a certain point, no further improvement in throughput can be attained.

A common procedure for installing, mounting and removing plates on a platesetter is disclosed in US 6412413 (TICE ET AL) 2002-07-02 which describes a media handling system including clamps for securing a printing plate on an external drum platesetter. Also, US 6794626 (KIERMEIER ET AL) 2004-09-21 discloses a method and system for verifying correct mounting of a printing plate on an external drum imaging machine. Both of these patents are herein incorporated by reference in their entirety for background information only.

### Disclosure of Invention

It is an object of the present invention to overcome the above identified and related problems in the prior art by increasing throughput of printing plates in an external drum platesetter.

The object is realised by providing an external drum platesetter having two or more drums aligned along a same rotational axis for supporting one or more printing plates, a single imaging head mounted on and moveable along one or more rails for transferring an image to the one or more printing plates, one or more motors for rotating the drums together or individually, and a computer for controlling operation of the platesetter in accordance with instructions stored or transferred to the computer.

The object is further realised by providing a method of operating an external drum platesetter having two or more drums aligned along a same rotational axis, wherein printing plates are imaged on one drum while other printing plates are removed and mounted on another drum, and vice versa.

Specific features for preferred embodiments of the invention are set out in the dependent claims.

### Brief Description of Figures in the Drawings

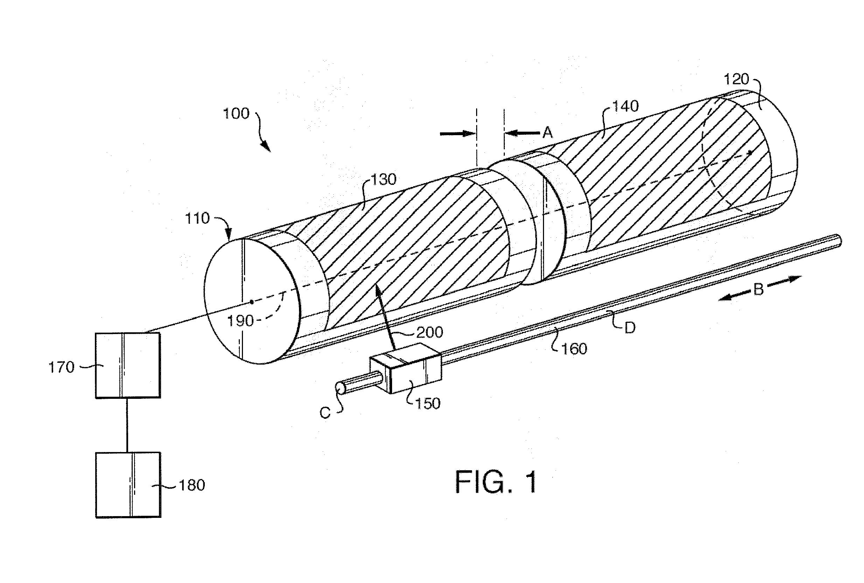

Fig. 1 (not drawn to scale) is a perspective view of portions of an external drum platesetter in accordance with the principles of the invention.

### Mode(s) for Carrying Out the Invention

In a first preferred embodiment or first operational mode, Figure 1 illustrates a portion of an external drum platesetter 100 used for imaging printing plates. Initially, one or more printing plates 130 are mounted on an outside surface of a first external drum 110 for imaging. Also one or more printing plates 140 are mounted on an outside surface of a second external drum 120. The plates 130 and 140 are mounted and secured in any known fashion, such as with edge clamps as described in US 6412413 (TICE ET AL) 2002-07-02. The two drums 110 and 120 are both aligned along a common rotational axis 190 which also represents a drive shaft or shafts for rotating the drums via one or more motors 170. The mounting surface for mounting printing plates on each drum is registered or calibrated with respect to the mounting surface of the other drum. The drums are separated by a gap A so that each drum can be independently operable.

The platesetter 100 includes a single imaging head 150 which includes a laser source and optics (not shown) for directing and focusing one or more laser beams 200 onto the printing plates for imaging. The imaging head 150 is moveable along one or more rails 160 in a linear direction B. In preparation for imaging printing plates mounted on the first drum 110 or the second drum 120, the imaging head is moved respectively to a first or second predetermined default position C or D. A computer or controller 180 is used to control the overall operation of the platesetter 100.

In the first embodiment, both drums have plates mounted thereon and are brought up to operational speed for imaging at the same time. Thereafter the drums are alternately stopped so that, either automatically or by an operator, the imaged plate or plates can be removed and new plates can be installed and secured for imaging. Then the drum is again brought up to operational speed and the second drum is stopped for removing imaged plates and installing new plates. The cycle continues so that one plate is always rotating for imaging while the other drum is in the mode of loading or unloading a plate.

In a second preferred embodiment or second operational mode, an operator will mount a first plate or plates 130 onto the first drum 110. The imaging head 150 is initially moved to a first predetermined default position C in preparation of imaging to the first printing plates 130 mounted on the first drum 110.

Software within the computer 180 will control the overall operation of the specific print jobs. For example, this software could be resident within the memory of the computer, it could be read from another source, it could be input via a compact disk or memory card, or it could be received by way of operator input on a keyboard (not shown).

The imaging head 150 is dependent upon the type of printing plates to be imaged. If the plates require high power, such as thermal ablation plates or thermal fused plates, then the laser source must be a high powered source (e.g. having a 830nm wavelength). On the other hand if the plates are sensitive to ultraviolet light, then the laser source within the imaging head must provide one or more laser beams consisting of ultraviolet light (e.g. having a 410nm wavelength). Other imaging heads could also be used on the platesetter, such as a laser head providing a laser beam of any known wavelength, or an ink jet printing head for ink jet transfer of an image.

Once the first plate or plates 130 are mounted on the first drum 110, then the motor and drive system 170 will start rotating the first drum 110 until it reaches a first predetermined operational speed for imaging. The imaging head 150 will thereafter begin transferring the desired image via the laser beam or beams 200 (or via ink jet) to the first printing plate or plates 130 on the first drum 110.

While the first drum is being brought up to speed by the drive system and motor 170 and the first plates 130 on the first drum 110 are being imaged, the operator can mount a second plate or plates 140 onto the second drum 120. Once the imaging of the first plates 130 on the first drum 110 is finished and the first drum 110 is being slowed to a stop, then the second drum 120 can be brought up to a second predetermined operational speed by the drive system and motor 170 for imaging.

The drive system and motor 170 are operational so that both the first and second drums 110, 120 can be rotated together at a same operational speed, or they can be operated separately and independently and at different operational speed if desired. The first and second predetermined operational speeds may vary according to the specific requirements of the particular print jobs on queue in the computer 180. The two drums can be physically locked together by mechanical means if desired.

In preparation for transferring an image onto the second plate or plates 140 of drum 120, the imaging head 150 will move along the rail or rails 160 along linear direction B and across the distance coincident with gap A to a second predetermined default position D. While the imaged first printing plate or plates 130 are being removed from the first drum 110 by the operator, then the second printing plate or plates 140 are being imaged by the imaging head 150 on the second drum 120.

Once the imaging of the second printing plate or plates 130 is complete, then the imaging head 150 will move along the rail 160 in the direction B and traverse the distance coincident with gap A along the rail or rails 160 to again move to the first predetermined default position C in preparation for imaging again to plates mounted on the first drum 110. The second drum 120 will be slowed to a stop to allow the operator to access and remove the second printing plate or plates 140 from second drum 120, while the first drum 110 is brought up to the first predetermined operational speed by the drive system and motor 170 in preparation for imaging to plates mounted thereon.

This cycle continues so that printing plates are nearly constantly being imaged. The idle or down time of the imaging head 150 is drastically reduced from the prior art teachings, and the throughput or number of printing plates imaged by the platesetter is significantly increased from the platesetters of the prior art.

In the manufacture of external drum platesetters, the imaging head is one of the most costly components. Thus, according to the present invention, a single costly imaging head is utilized for maximum use in contrast to a conventional prior art system whereby the imaging head is idle during the period of time that is necessary to stop the drum, unload the plates, re-install new plates, and bring the drum back up to imaging speed.

Many different embodiments of the external drum platesetter shown in Figure 1 are included in the invention as claimed. For instance, the number of drums aligned along a common rotational axis within a single machine is not limited to two.

The motor and drive system for mechanically rotating the drums includes any known drive system currently available, as long as the drums can optionally be independently rotated and stopped. Optionally the multiple drums can be connected to turn together, for example, by inserting a pin across the gap A to connect the drums, or locking the drive shaft. In this way, an operator can mount a large printing plate that would not fit on a single drum.

The exact timing between starting, stopping and operating each drum is not critical so long as the overall gist of the invention is maintained to allow that one portion of the platesetter to nearly always in the mode of transferring an image to printing plates, while another portion of the platesetter is in the mode of plate transfer to or from the drum.

While this invention has been particularly shown and described with references to preferred embodiments thereof, it will be understood by those skilled in the art that various form changes in and details may be made therein without departing from the scope of the invention as defined by the appended claims.

## Claims

1. An external drum platesetter (100), comprising:
- a drum (110) aligned along a rotational axis (190), for supporting one or more printing plates (130);
- one or more rails (160) positioned parallel to the rotational axis (190) of the drum (110);
- a single imaging head (150) mounted on and moveable along the one or more rails (160), for transferring an image to the one or more printing plates (130);
- a motor (170) for rotating the drum (110), and;
- a computer (180) for controlling operation of the platesetter (110) in accordance with instructions stored or transferred to the computer (180);
**characterised in that** the external drum platesetter (100) further comprised one or more additional drums (120) aligned along the rotational axis (190), for supporting one or more additional printing plates (140), wherein the single imaging head (150) is further moveable along the one or more rails (160) for transferring an image to the one or more additional printing plates (140) and the motor (170) is further for rotating the one or more additional drums(120).

2. The external drum platesetter (100) according to claim 1, further comprising one or more additonal motors (170) for rotating the one or more additional drums (120) individually.

3. The external drum platesetter (100) according to any one of the previous claims, wherein the single imaging head (150) is a thermal, violet or inkjet imaging head.

4. The external drum platesetter (100) according to any one of the previous claims, wherein the single imaging head (150) comprises a laser source and optics for transferring the image to the one or more printing plates (130) or the one or more additional printing plates (140).

5. A method of operating an external drum platesetter (100) for transferring one or more images to one or more printing plates (130, 140), the method comprising the steps of:
(a1) mounting and securing the one or more printing plates (130) onto an external surface of a first drum (110);
(b1) rotating the first drum (110) around a rotational axis (190) to a first predetermined operational speed in preparation for imaging;
(c1) transferring one or more images using an imaging head (150) to the one or more printing plates (130) mounted on the first drum (110);
(d1) stopping the first drum (110) upon completion of imaging the one or more printing plates (130) mounted on the first drum (110);
(e1) removing the one or more plates (130) from the first drum (110) and mounting and securing one or more new printing plates onto the external surface of the first drum (110);
(f1) rotating the first drum (110) along the rotational axis (190) to the first predetermined operational speed in preparation for imaging; and
(g1) repeating the above steps (c1) through (f1); **characterized in that** the method further comprises the steps of:
(c2) simultaneously with step (c1), mounting and securing one or more additional printing plates (140) on an external surface of a second drum (120), the first drum (110) and the second drum (120) sharing the same rotational axis (190);
(d2) simultaneously with step (d1), rotating the second drum (120) along the rotational axis (190) to a second predetermined operational speed in preparation of imaging;
(e2) simultaneously with step (e1), transferring one or more images using the imaging head (150) to the one or more additional printing plates (140) mounted on the second drum (120);
(f2) simultaneously with step (f1), stopping the second drum upon completion of imaging the one or more additional printing plates (140) mounted on the second drum (120); and
(g2) repeating the above steps (c2) through (f2).

6. The method of claim 5, wherein the imaging head (150) comprises a laser source and optics for transferring the one or more images to the one or more printing plates (130) or one or more additional printing plates (140).

7. The method of claim 6, wherein the imaging head (150) is a thermal imaging head.

8. The method of claim 6, wherein the imaging head (150) is a violet imaging head.

9. The method of claim 5, wherein the imaging head (150) is an inkjet imaging head.

10. A method of operating an external drum platesetter (100) for transferring one or more images to one or more printing plates (130, 140), the method comprising the steps of:
- transferring one or more images using a single imaging head (150) to one or more printing plates (130) mounted on external surfaces of a first drum (110) rotating along a rotational axis (190);
- stopping a first drum (110) upon completion of imaging printing plates (130) mounted on the first drum (110);
- removing the printing plates (130) from the first drum (110);
- installing new printing plates (130) on the first drum (110);
- rotating the first drum (110) in preparation for imaging;
**characterized in that** the method further comprises the steps of:
- transferring one or more images using the single imaging head (150) to one or more additional printing plates (140) mounted on external surfaces of one or more additional drums (120) rotating along the rotational axis (190);
- continuing to image the one or more additional printing plates (140) mounted on the one or more additional drums (120) during the steps of stopping the first drum (110), removing the printing plates (130), installing new printing plates (130), and rotating the first drum (110) in preparation for imaging.

11. The method according to claim 10, further comprising:
- stopping a second drum (120) of the one or more additional drums (120) upon completion of imaging printing plates (140) mounted on the second drum (120);
- removing the printing plates (140) from the second drum (120);
- installing new printing plates (140) on the second drum (120);
- rotating the second drum (120) in preparation for imaging;
- continuing to image the printing plates (130) mounted on the first drum (110) during the steps of stopping the second drum (120), removing the printing plates (140), installing new printing plates (140), and rotating the second drum (120) in preparation for imaging.

12. The method according to claim 10 or 11, wherein the imaging head (150) is an inkjet imaging head, a thermal imaging head or a violet imaging head.
